(19) Europäisches Patentamt
European Patent Office
Office européen des brevets

(11) **EP 1 901 309 B1**

(12) **EUROPEAN PATENT SPECIFICATION**

(45) Date of publication and mention
of the grant of the patent:
**28.04.2010 Bulletin 2010/17**

(51) Int Cl.:
***G11C 16/04*** *(2006.01)*    ***G11C 16/26*** *(2006.01)*
***G11C 16/32*** *(2006.01)*    ***G11C 29/00*** *(2006.01)*

(21) Application number: **06425631.6**

(22) Date of filing: **13.09.2006**

(54) **Method of fixing read evaluation time in a non volatile nand type memory device**

Verfahren zum Festlegen der Leseauswertungszeit in einer nicht-flüchtigen NAND-Speichervorrichtung

Procédé de fixation du temps d'évaluation de lecture dans un dispositif de mémoire non volatile du type non-et

(84) Designated Contracting States:
**DE**

(43) Date of publication of application:
**19.03.2008 Bulletin 2008/12**

(73) Proprietors:
• **STMicroelectronics Srl**
  **20041 Agrate Brianza (MB) (IT)**
• **Hynix Semiconductor Inc.**
  **Ichon-si,**
  **Kyoungki-do 467-701 (KR)**

(72) Inventors:
• **Crippa, Luca**
  **20040 Busnago (IT)**
• **Ravasio, Roberto**
  **24036 Ponte San Pietro (IT)**
• **Micheloni, Rino**
  **22078 Turate (IT)**

(74) Representative: **Kraus, Jürgen Helmut et al**
**Leinweber & Zimmermann**
**Rosental 7**
**80331 München (DE)**

(56) References cited:
**EP-A- 1 610 335    US-A1- 2004 027 855**

**Description**

The present invention relates generally to non volatile memory devices and more particularly to NAND-type devices.

The evaluation time of the programmed or erased state of a cell of a non volatile NAND memory array during read or verify operations is normally fixed during a test-on-wafer phase of the devices or is set by a known board microcontroller at a power on of the device by executing a self-configuration program code stored, together with pre-established configuration values.

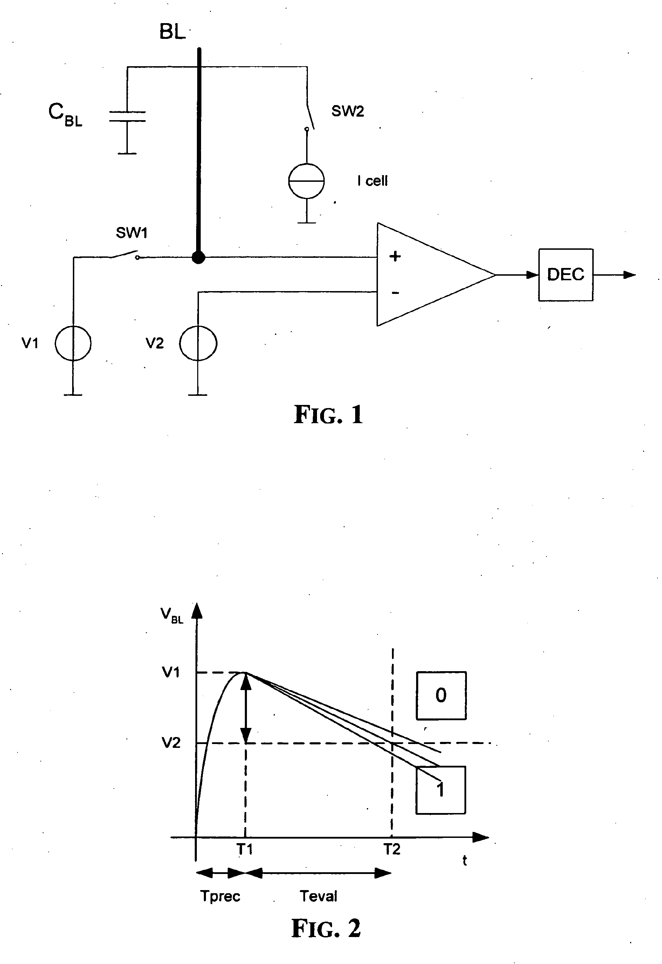

A typical circuit diagram for read (evaluation) operations of NAND memory devices is depicted in Figure 1.

The scheme contemplates the charging to a certain read voltage V1 of the capacitance associated to a bitline BL. Referring to the diagram of Figure 1 and to the relative timing diagram of Figure 2, at the instant T1, the switch SW1 opens, leaving the bitline BL charged at the read voltage V1. Simultaneously, the NAND string to which the selected cell belongs is activated through a row decoding circuit, electrically represented by the switch SW2 and the relative current generator Icell of Figure 1.

Assuming that the current flowing through the cell string is constant and depends solely from the threshold voltage of the selected cell and from the voltage of the selected wordline WL, the current generator Icell starts to discharge the bitline BL at the instant T1.

Accordingly the voltage on the bitline BL evolves according to the following equation:

$$V_{BL}(t) = V1 - Icell * Teval / C_{BL} \qquad (1)$$

The evaluation time interval is given by:

$$Teval = T2 - T1 \qquad (2)$$

At the end of the evaluation time internal Teval, that is at the instant T2, the result of the comparison between the voltage on the bitline BL and the discrimination voltage threshold V2, determines the value that is recognized by the discriminating circuit DEC, according to the following criteria:

$$\text{if } VBL(T2) > V2$$
$$\text{Cell @ 0}$$
$$\text{else}$$
$$\text{Cell @ 1} \qquad (3)$$
$$\text{end if.}$$

When programming a cell threshold voltage is incremented as far as, for a predetermined voltage (PV) applied to the relative wordline WL, the current flowing through the cell at the end of the evaluation time will have decreased to a value such that:

$$VBL(T2) \geq V2 \qquad (4)$$

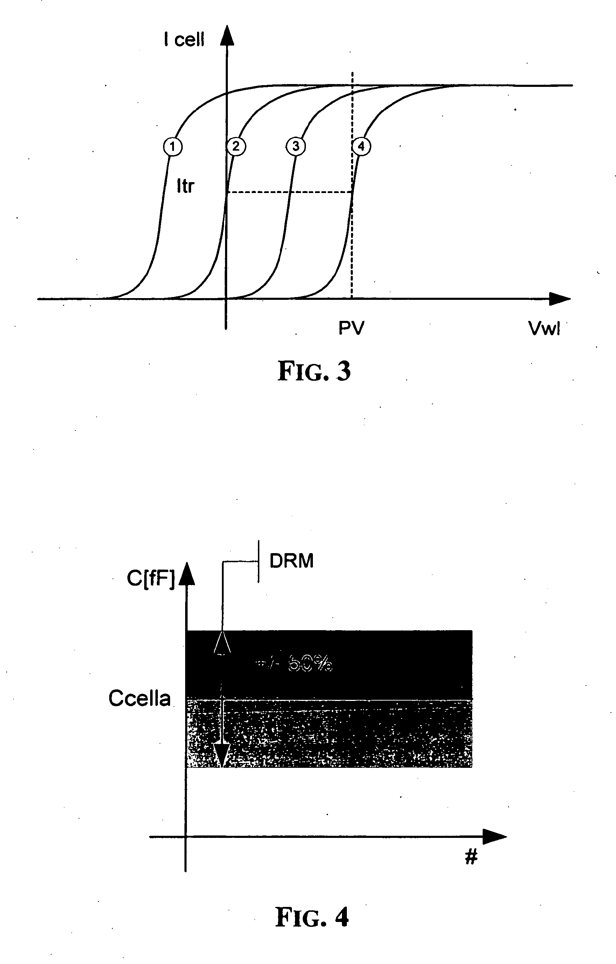

and therefore the cell will be recognized as having a logic "0" content, as depicted in Figure 3.

At equilibrium, the following equation holds;

$$V_2 = V_1 - Icell * Teval / C_{BL} \qquad\qquad (5)$$

Once the voltage levels V1 and V2 and the evaluation time interval Teval are fixed, the maximum value of current flowing through the cell for which the cell is recognized as being programmed to the logic value "0" will be determined by the capacitance of the relative bitline BL, being

$$Icell = (V_1 - V_2) * C_{BL} / Teval \qquad\qquad (6)$$

Should the capacitance of all the bitlines of the memory array be equal, all the cells would have the same discharge current. Unfortunately this is not the case because the capacitance of the bitlines as normally set out in a design rule manual of these memory devices, is extremely variable, normally being indicated with $\pm$ 50% range of variability, as graphically depicted in Figure 4.

As a consequence, the value of the current flowing through a cell, given by the relationship (6), has a large variance.

In Figure 5 are depicted the currents through a cell during the charging phase (time interval 0-T1) and diving the discharge phase (in the interval from T1 to T2) for three different bitlines BL, having respectively a minimum capacitance (Cmin), a typical capacitance (Ctyp) and a maximum capacitance (Cmax) of the indicated range of variability.

Figure 6 represents the electric charge $Q_{Cmax}$ $Q_{Cmin}$ and $Q_{Ctyp}$ that is stored in the respective bitline.

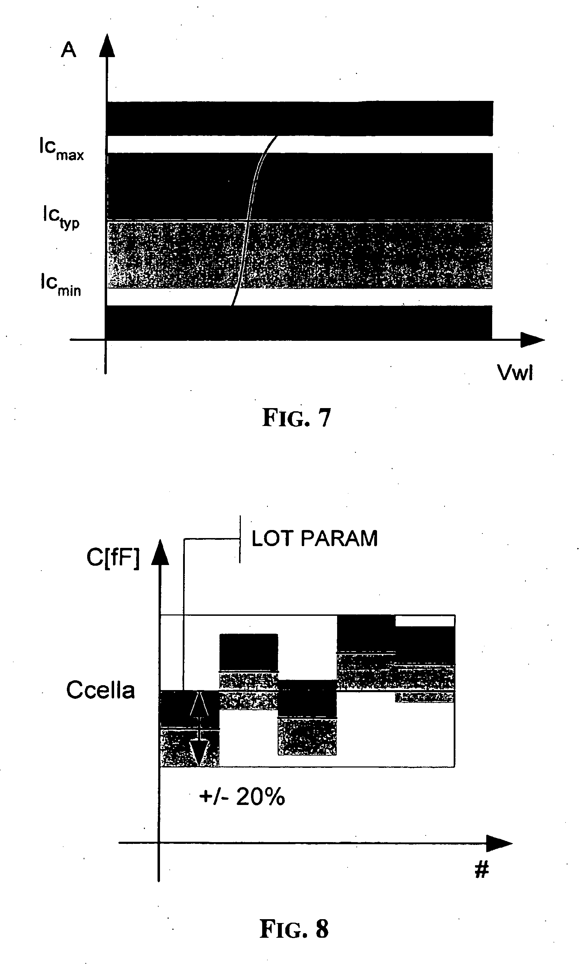

Thus, the turning point of a cell shifts considerably over its characteristic. Therefore, when designing the memory device it must be ensured that for any possible value of capacitance of the single array bitline there will be a working point (or turning point current) (Iturn < ICmax) that will have an adequate safety margin in order to avoid zones strongly non linear of the characteristic curve (e.g. the bottom and top darker regions in the diagram of Figure 7).

With the constant reduction of the sizes of integrated structures, the maximum current through the cells (Icell max) diminishes while the spread of parasitic capacitance values of the bitlines increases. This makes more and more difficult to define an operating zone of guaranteed correct functioning.

Document EP 1 610 335 discloses a method and device for fixing of evaluation tome of a programmed or erased non-volatile memory cell. The method includes calibration of the triggering time" in function of a memory cell discharge current, a charge voltage and a read discrimination voltage.

SUMMARY OF THE INVENTION

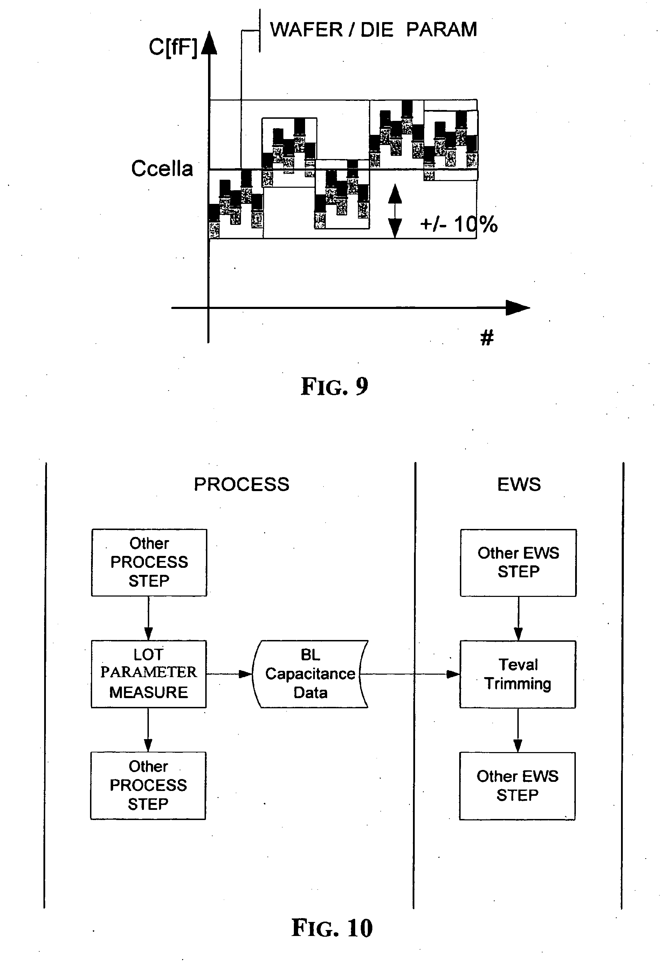

A campaign of tests has revealed that the spread of bitline parasitic capacitance values that is commonly reported in a design rule manual of memory devices in order to enable the designer to establish with a sufficiently safe margin factor in defining the operating point or zone of operation that will ensure a faultless functioning of the device and that is replicated in the graphical representation of Figure 8, compounds in fact different spread contributions, namely an intra-die topological variability, a intra-lot of wafer spread as depicted in Figure 9, and the spread among different lots of wafers as depicted in Figure 10.

Recognition of the relative weights of the above mentioned bitline parasitic capacitance value spread contributions to the compound spread values indicated in design rule manuals, has lead the applicants to envisage an effective way of contrasting the shrinking of the secure operating zone of the electrical characteristics of scaled down cell arrays of the memory device through an improved method of fixing an appropriate evaluation time interval (Teval) on the basis of a specific parasitic capacitance value of the bitlines of the memory cell array assessed for each individual device either once for all during a test-on-wafer phase or even repeatedly in utilizing the finished memory device.

According to this invention, the evaluation time (Teval) of the programmed or erased state of a cell of the NAND memory array is set for the individual memory device in a way that at least partially compensates the generally large spread of parasitic capacitance values of the array bitlines in the mass production fabrication process of these devices.

Of course, the optimized establishing of working parameters of the single device may even be implemented by adjusting the difference between the read charge voltage (V1) and the read discrimination voltage (V2), or alternatively the fixing of the evaluation time (Teval) may compensate a process spread of such a voltage difference, as will be evident to the skilled reader.

According to a preferred embodiment of this invention, an average value of capacitance of a single bitline of the memory array assessed for a certain lot of wafers is used during the test-on-wafer phase for fixing the most appropriate evaluation time, thus taking advantage of the significantly narrower intra-lot spread of bitline parasitic capacitance values compared to the compounded spread indicated in the design rule manual of the device.

A more preferred embodiment contemplates the integration of dedicated internal circuit structures for measuring the average parasitic capacitance of the bitlines of the memory cell array of the individual device.

According to yet another embodiment of this invention, one or more dummy bitlines and associated circuit structures are formed for measuring the average time needed by the dummy bitlines to discharge from the read charge voltage V1 to the read discrimination voltage V2 with a desired current Icella. Given that it may be reasonably supposed that the dummy bitlines have the same capacitance of the user addressable bitlines, the evaluation time Teval is fixed equal to the so measured time interval.

The invention is defined in the annexed claims.

BRIEF DESCRIPTION OF THE DRAWINGS

Sample embodiments of the invention will be described referring to the attached drawings, wherein:

**Figure 1** depicts schematically a bitline of a nonvolatile NAND memory device and the circuit used for discriminating the state of a cell;
**Figure 2** is a graph of the charge voltage of a bitline during a read operation;
**Figure 3** depicts four sample voltage-current characteristics of a memory cell;
**Figure 4** depicts a sample range of tolerance of the mean value of the capacitance of a bitline as indicated in the Design Rule Manual;

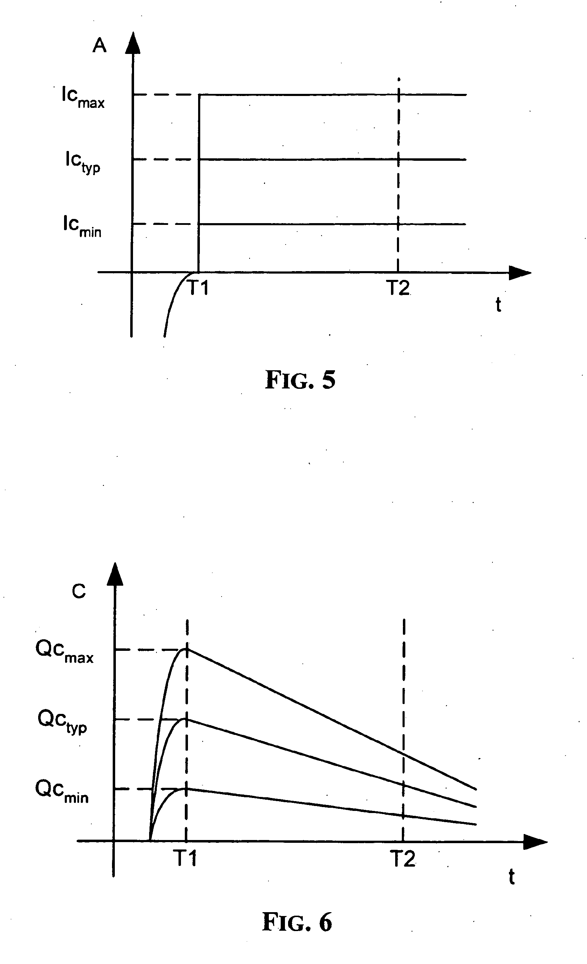

**Figure 5** is a graph of the maximum, minimum and typical discharge current of a bitline during a read operation;
**Figure 6** is a graph of the maximum, minimum and typical electric charge stored in a bitline during a read operation;
**Figure 7** highlights the preferred functioning zone of the voltage-current characteristic of a bitline;
**Figure 8** depicts a typical range of tolerance of the mean value of the capacitance of the bitlines of a memory device as measured during a test on wafer (EWS) phase;
**Figure 9** depicts a typical range of tolerance of the mean value of the capacitance of the bitlines of all memory devices of a wafer as measured during a test on wafer (EWS) phase;
**Figure 10** is a basic flow chart that shows how the EWS phase is modified according to a first embodiment of this invention;

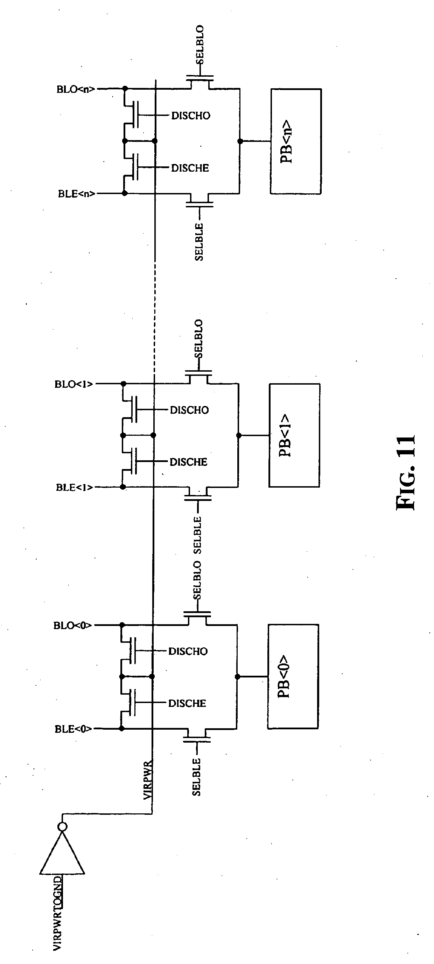

**Figure 11** depicts the page buffers and the selection switches of the bitlines of a nonvolatile NAND memory device;

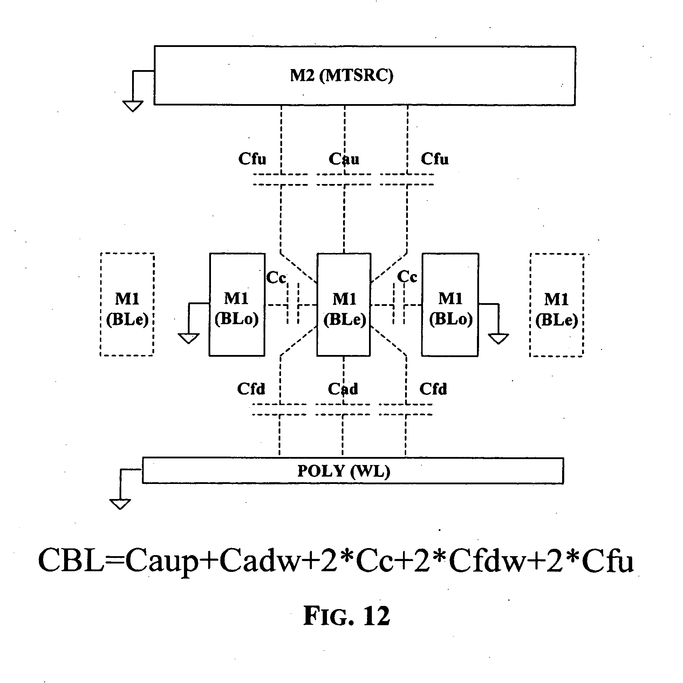

**Figure 12** illustrates the various coupling capacitances of a bitline with various parts of the memory device;

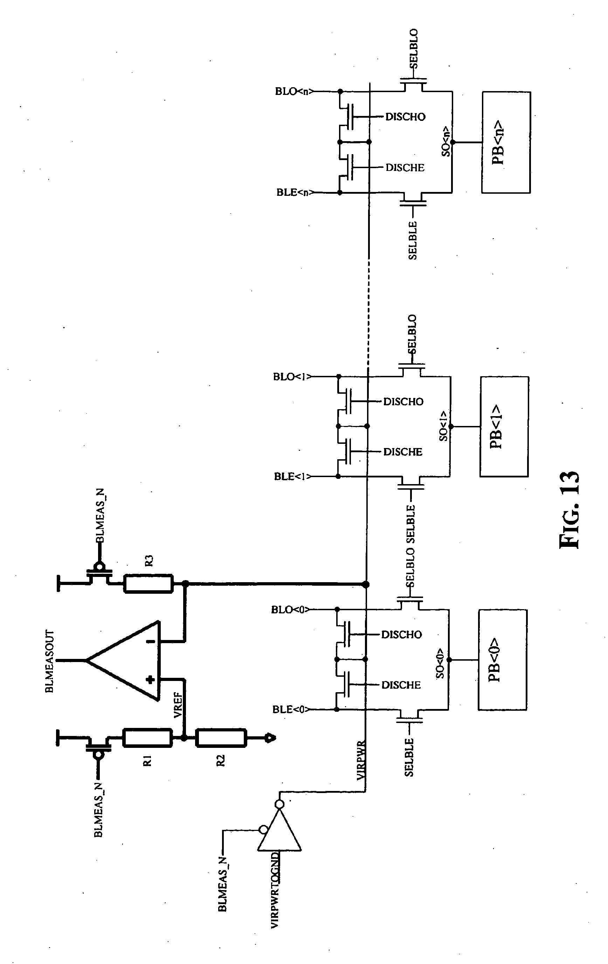

**Figure 13** depicts a first embodiment of a nonvolatile memory device of this invention that includes a circuit for establishing an evaluation time for discriminating the state of a cell being read;

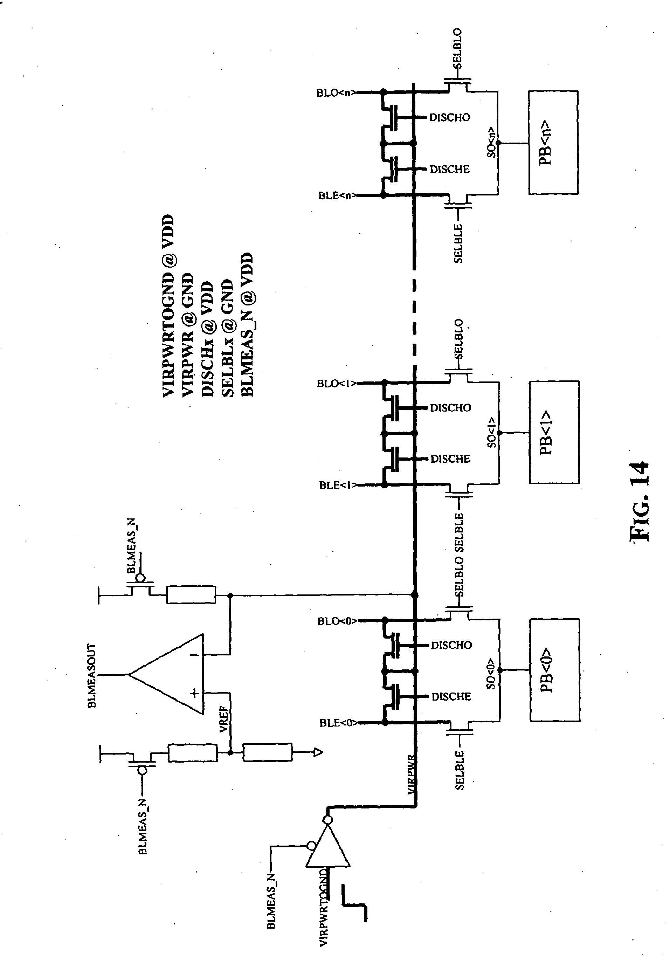

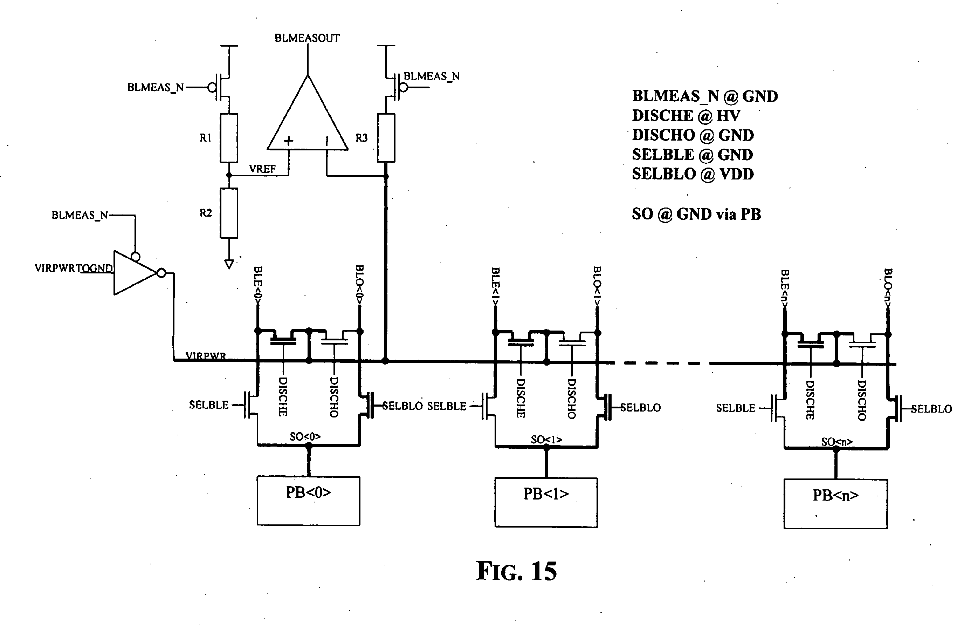

**Figures 14 and 15** illustrate two functioning conditions of the device of Figure 13;

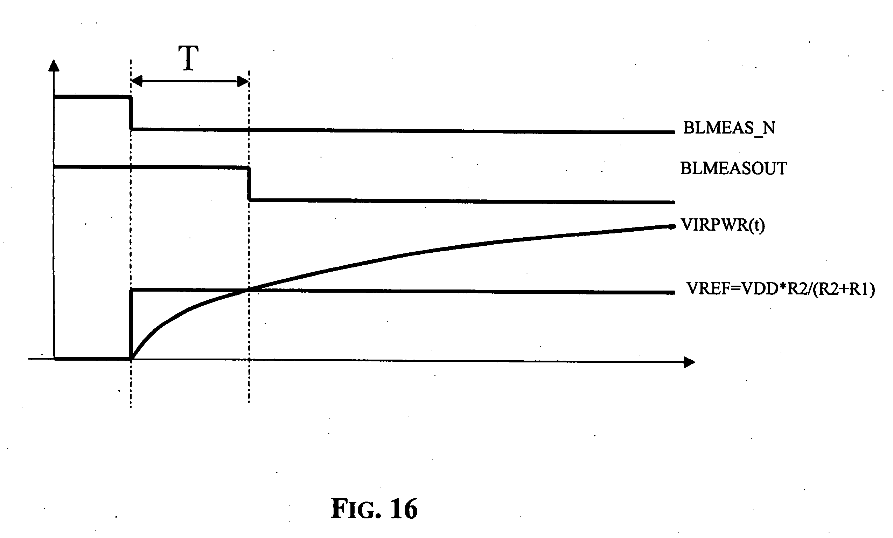

**Figure 16** depicts time graphs of the main signals of the memory device of Figures 14 and 15;

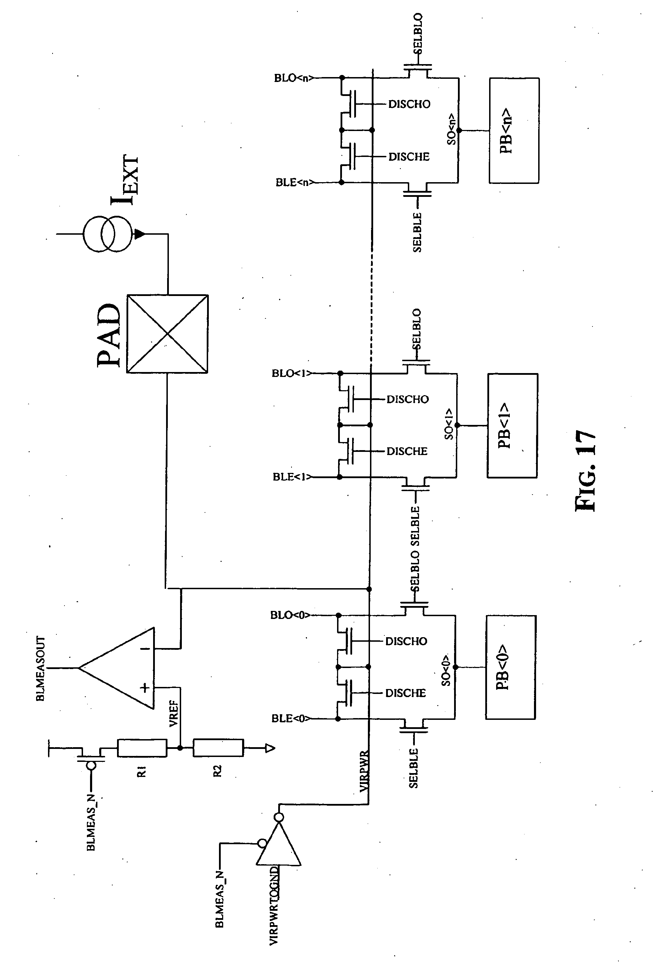

**Figure 17** depicts a second embodiment of a nonvolatile memory device of this invention that includes another circuit for establishing an evaluation time for discriminating the state of a cell being read;

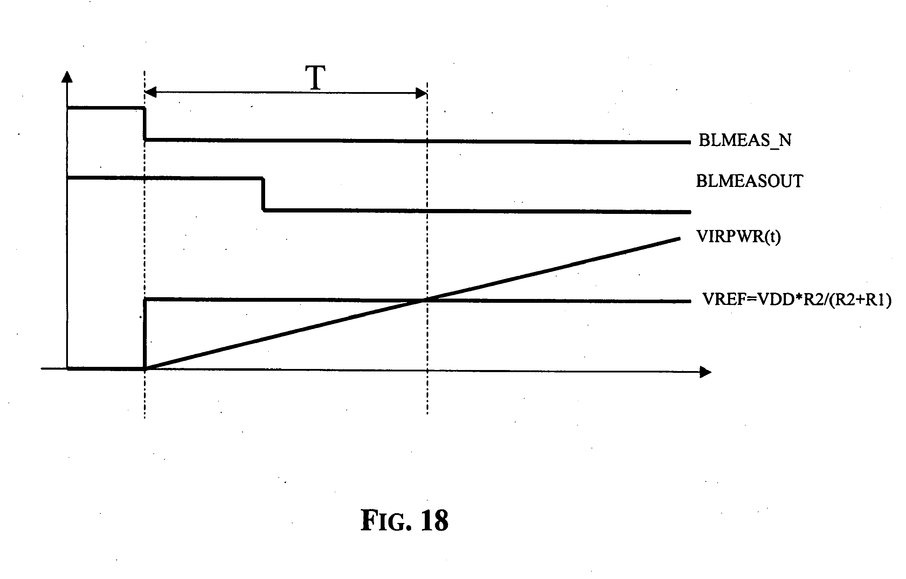

**Figure 18** depicts time graphs of the main signals of the memory device of Figure 17;

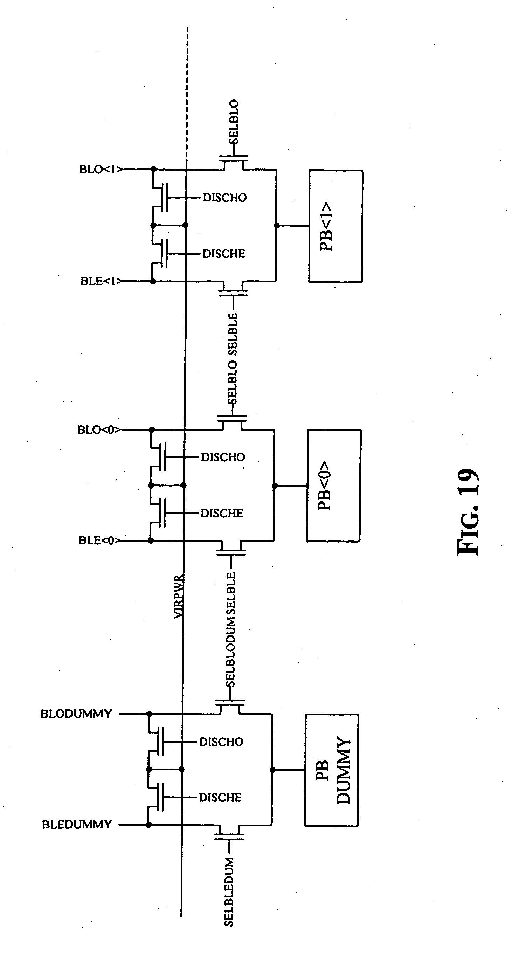

**Figure 19** schematically illustrate a third embodiment of a nonvolatile memory device of this invention that includes at least a dummy bitline and a dummy page buffer specifically designed for establishing the evaluation time of the bitlines effectively made available to a user;

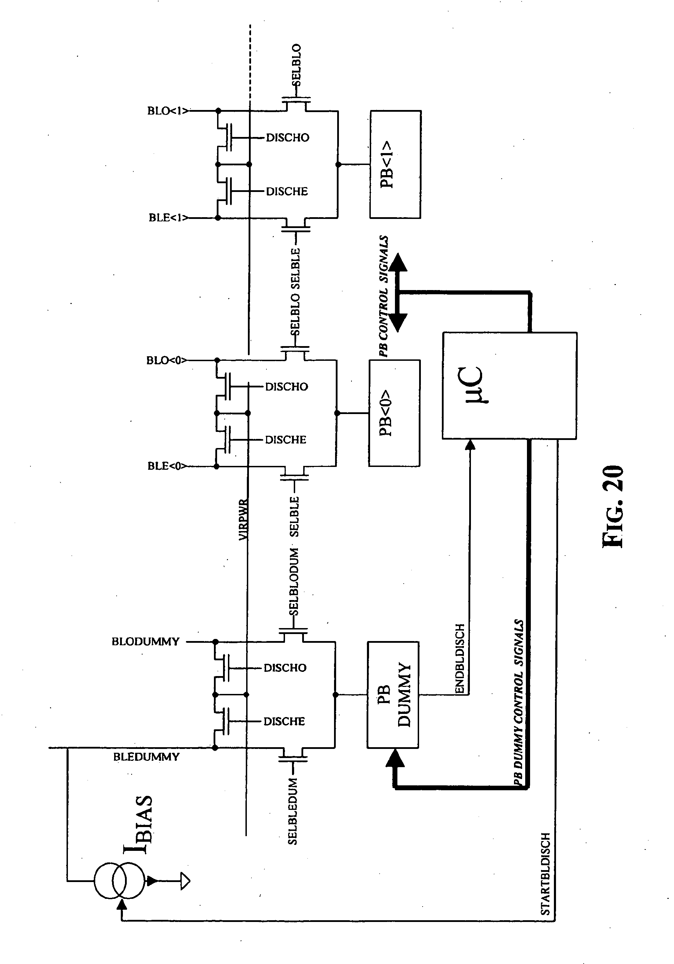

**Figure 20** schematically illustrates how a microprocessor integrated in the memory device of Figure 19 measures the evaluation time of a dummy bitline and uses this information for controlling the page buffers of the memory;

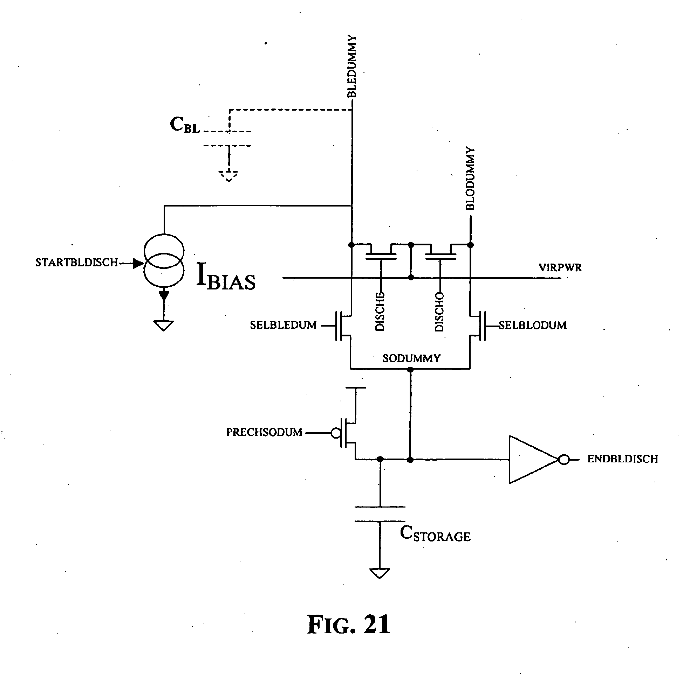

**Figure 21** is a detailed view of the dummy page buffer depicted in Figures 19 and 20;

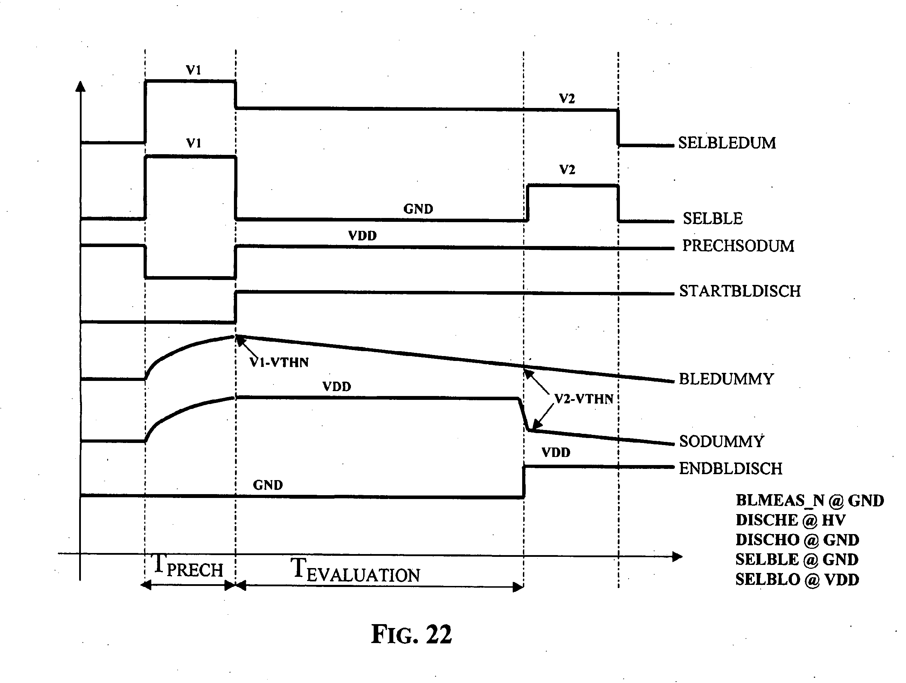

**Figure 22** depicts time graphs of the main signals of the memory device of Figures 20 and 21.

DESCRIPTION OF SEVERAL EMBODIMENTS OF THE INVENTION

This invention provides several methods for fixing the evaluation time necessary for discriminating the state of a memory cell being read.

A first and a second method of this invention contemplate the operation of determining the evaluation time by measuring during a test on wafer (EWS) phase the mean capacitance $C_{BL}$ of the bitlines and calculating in function thereof and of the read charge voltage V1, the read discrimination voltage V2 and of a certain pre-established discharge current Icell through the cell during a read operation.

According to an innovative aspect of the first and second method of this invention, the evaluation time Teval may be fixed once and for all by trimming fuses of the nonvolatile memory device during the EWS phase, or it may be fixed at each power on of the memory device, or when an erase phase or a read phase is started.

The mean capacitance $C_{BL}$ of the bitlines may be determined during an EWS phase of the device being fabricated by measuring the capacitance of the bitlines of the memory device (Figure 8) or of the bitlines of all the memory devices on a same wafer (Figure 9). Indeed, it has been noticed that the capacitance measured in this phase is determined with a range of tolerance relevantly smaller than that indicated in the Design Rule Manual (Figure 4), thus using the so calculated mean value allows to determine in a more precise manner the evaluation time Teval.

It is evident that carrying out such a modified EWS phase, schematically sketched in Figure 10, on a NAND memory device (Figure 11) being fabricated would significantly improve the precision of the discrimination of the state of a cell being read, and thus reduce the error probability of a read operation.

As an alternative, it is possible to measure the mean total capacitance value $C_{BL}$ of a bitline, that is the sum of various contributions (Figure 12), with a dedicated circuit integrated with the memory device, and using the value $C_{BL}$ for fixing the evaluation time at the power on of the memory device or when an erase or read operation is started.

Figure 13 depicts a memory device of this invention that integrates a dedicated circuit (drawn with a thick line) for measuring the mean capacitance $C_{BL}$. This dedicated circuit allows to calculate the total capacitance of a plurality of bitlines, by connecting in parallel to a common line VIRPWR the plurality of bitlines, for example the even or the odd bitlines of the memory device, then the mean capacitance $C_{BL}$ is obtained by dividing the total capacitance by the number of bitlines connected in parallel.

More in detail, the total capacitance is measured as follows. First, all the bitlines of the memory device are grounded by connecting them to the common line VIRPWR. This is done by enabling the signals DISCHE and DISCHO (Figure 14) when the line VIRPWR is at a ground potential, that is when the signal VIRPWRTOGND is active.

Then the odd or even bitlines are kept grounded (Figure 15) by disabling the signal DISCHO or DISCHE and enabling the signals SELBLO or SELBLE, respectively. While the odd or even bitlines, respectively, are kept grounded, the signal BLMEAS_N is disabled (Figure 16), thus the common line VIRPWR is left floating (threestated) and it is charged through the resistor R3. When the voltage on the threestated common line VIRPWR reaches the reference voltage VREF generated by the voltage divider R1, R2, the flag BLMEASOUT switches.

By measuring the time T required for charging the common line VIRPWR, it is possible to calculate the total capacitance of the even or odd (or of all the) bitlines. Indeed,

$$VREF = VDD \cdot \frac{R2}{R1 + R2} \qquad (1)$$

and the voltage on the common line VIRPWR increases according to the following equation:

$$VIRPWR(t) = VDD \cdot \left( 1 - \exp\left( -\frac{t}{R3 \cdot n \cdot C_{BL}} \right) \right) \qquad (2)$$

being n the number of bitlines connected in parallel to the common line VIRPWR. Therefore, when the flag BLMEASOUT switches, a time T has elapsed such that

$$VIRPWR(T) = VDD \cdot \left( 1 - \exp\left( -\frac{T}{R3 \cdot n \cdot C_{BL}} \right) \right) = VDD \cdot \frac{R2}{R1 + R2}$$

By measuring this time interval T, it is possible to calculate the mean capacitance value $C_{BL}$ using the following equation:

$$C_{BL} = \frac{T}{n \cdot R_3 \cdot \ln\left(\frac{R1 + R2}{R1}\right)} \qquad (3)$$

It is worth noticing that tolerances of fabrication of the resistor R3 may increase the uncertainty range of $C_{BL}$. For this reason according to another embodiment of this invention, the circuit of Figure 17 is preferred. The functioning is similar to that of the circuit of Figure 14, but the common line VIRPWR is charged by a current generator $I_{EXT}$ connected to it through a pad of the memory device. In this case, the voltage on the line VIRPWR increases (Figure 18) according to the following equation:

$$VIRPWR(t) = \frac{I_{EXT} \cdot t}{n \cdot C_{BL}} \qquad (4)$$

thus the time T satisfies the following equation:

$$VIRPWR(T) = \frac{I_{EXT} \cdot T}{n \cdot C_{BL}} = VDD \cdot \frac{R2}{R1 + R2} \qquad (5)$$

and the mean capacitance value $C_{BL}$ is

$$C_{BL} = \frac{I_{EXT} \cdot T}{n \cdot VDD \cdot \frac{R2}{R1 + R2}} \qquad (5)$$

Therefore, the value $C_{BL}$ does not depend on the resistance R3.
According to another embodiment of this invention, the evaluation time Teval may be fixed without measuring the mean capacitance of the bitlines. This may be done in a memory device of Figure 19, that includes spare memory cells connected to dummy bitlines BLEDUMMY, BLODUMMY controlled by a properly designed page buffer PB DUMMY.
Figure 20 depicts a more detailed view of the memory device of Figure 19, that shows also how a microcontroller μC conditions all the page buffers of the memory device.
In practice, according to another method of this invention for fixing the evaluation time Teval, it is supposed that the capacitance of the dummy bitline BLEDUMMY or BLODUMMY (or the mean capacitance of all the dummy bitlines of the memory device), be substantially equal to the mean capacitance of the bitlines addressable by a user. With this assumption, the evaluation time Teval is the time required by a dummy bitline BLEDUMMY (or BLODUMMY) to discharge from the charge read voltage V1 to the discrimination read voltage V2 when a current Icell is drawn therethrough.
More in detail, first the signals SELBLE and SELBLEDUM are made equal to the voltage V1, thus the dummy bitline BLEDUMMY (or BLODUMMY) and the bitlines addressable by the user are biased approximately with the voltage V1 (as a matter of fact they are biased with the voltage V1-Vth wherein Vth is the threshold voltage of the selection switch).
Then the signal SELBLE is grounded and SELBLEDUM is set to the discrimination voltage V2. At the same time, the microcontroller μC enables a start flag STARTBLDISCH and the current generator Icell starts discharging the dummy line BLEDUMMY.
When the voltage on the dummy bitline BLEDUMMY drops such to turn off the respective selection switch (that is the voltage on the bitline dummy is V2-Vth), the dummy page buffer PB DUMMY detects this event and switches the flag ENDBLDISCH. Therefore, the microcontroller μC fixes the time Teval as the time interval between an active edge of the start flag STARTBLDISCH and the subsequent edge of the flag ENDBLDISCH.

This method of fixing the evaluation time Teval is particularly convenient because it may be implemented at each power on of the memory device, or at the beginning of each erase phase or even before executing each read phase. Therefore, even if the capacitance of addressable bitlines of the memory device varies, because of fluctuations of temperature or of other functioning conditions, this technique may provide the value Teval for correctly discriminating the state of the memory cells.

Figure 21 is a detailed view of a sample embodiment of the dummy page buffer PB DUMMY of Figure 20.

Figure 22 is a time diagram of the signals of Figure 21, that illustrates the above described technique.

It is worth remarking that it is possible to connect n dummy bitlines in parallel and determining the evaluation time Teval according to the previous technique by using a discharge current generator that draws a current $n$*Icell.

**Claims**

1. A method of fixing an evaluation time (Teval) of a programmed or erased state of a cell of an array of rows and columns of cells of a non volatile NAND memory device, individually addressable through word lines and bitlines chargeable at certain read voltage levels, said evaluation time passed from the instant a bitline of a cell is charged at a read charge voltage (V1), a sense circuit assesses the state of the cell in order to produce at an output of the memory device a certain read data, comprising the steps of
fixing said evaluation time (Teval) of each memory device in function of at least said read charge voltage (V1) of the bitline, of a read discriminating voltage (V2) and of a certain discharge current through the cells (Icell) once for all during a test-on-wafer phase (EWS) of the device or repeatedly during operation of the finished memory device; the method is **characterised in that** it comprises the steps of :

   measuring a capacitance of a predefined plurality of bitlines of the array;
   establishing an average value of bitline capacitance (CPL) based on the measured capacitance; and
   fixing said evaluation time (Teval) of the memory device as a function of said average value of bitline capacitance (CBL).

2. The method according to claim 1, wherein said evaluation time (Teval) is fixed at a phase of operation of the memory device chosen from the power-on phase and at start of an erase or read operation.

3. The method according to claim 1, including the steps of:

   measuring the total capacitance of even or odd bitlines of the memory array;
   establishing said average value of bitline capacitance (CBL) by dividing the measured total capacitance by the number of either even or odd bitlines charged to said read charge voltage (V1) in parallel.

4. The method of claim 3, comprising the steps of:

   biasing either all even or all odd bitlines of the memory array by connecting them in parallel to a common ground line;
   charging in parallel said bitlines by connecting said common line to a power supply rail of the memory device through an auxiliary resistance (R3);
   comparing the voltage on said common line with a reference voltage VREF;
   measuring the charging time (T) of said bitlines for reaching on said common line a voltage equal to said reference voltage (VREF);
   calculating the total capacitance of said bitlines in function of said time of charging (T) of said auxiliary resistance (R3) and of said reference voltage (VREF).

5. The method of claim 3, comprising the steps of
   biasing either all even or all odd bitlines of the memory array by connecting them in parallel to a common ground line;
   charging in parallel said bitlines by connecting said common line to a constant current generator of a certain current (IEXT);
   comparing the voltage on said common line with a reference voltage VREF;
   measuring the charging time (T) of said bitlines for reaching on said common line a voltage equal to said reference voltage (VREF);
   calculating the total capacitance of said bitlines in function of said time of charging (T) of said auxiliary resistance (R3) and of said reference voltage (VREF).

6. The method of claim 2, wherein said memory device comprises additional dummy bitlines memory cells, the method comprising the steps of biasing at least one of said dummy bitlines at said read charging voltage (V1);

discharging said dummy bitlines at said certain pre-established discharge current (Icell);
fixing said evaluation time (Teval) by measuring the time needed for discharging said dummy bitline from said read charging voltage (V1) to said read discrimination voltage level (V2).

7. The method according to claim 1, including the steps of:

fixing said evaluation time (Teval) of each memory device in function of at least said read charging voltage (V1) of the bitlines, of a read discrimination voltage level (V2), of a certain discharge current through said cell (Icell) and of said average capacitance value (CBL) through the setting of trimming fuses of the memory device.

8. A non volatile NAND type memory device including a circuit for fixing an evaluation time (Teval) of a programmed or erased state of a cell of an array of rows and columns of cells, individually addressable through word lines and bitlines chargeable at respective read charging voltage, said evaluation time passed from the instant a bitline of a cell is charged at a read charge voltage (V1), a sense circuit assesses the state of the cell in order to produce at output of the memory device a certain read data, said circuit for fixing the evaluation time (Teval) comprising:

a voltage divider (R1, R2) referred to ground and connected to a power supply line of the memory device through a switch controlled by a control signal (BLMEANS_N), generating a reference voltage (VREF);
a comparator for comparing the voltage on a common line of said bitlines of the memory array with said reference voltage (VREF), generating a flag (BLMEASOUT) active when said reference voltage (VREF) is surpassed;

characterised in that the memory device includes
circuit means for charging said common line of said bitlines, wherein a time to charge said common line is determined based on the generated flag (BLMEASOUT); an average value of bitline capacitance (CBL) is established based on the time to charge said common line; and the evaluation time (Teval) is fixed as a function of said average value of bitline capacitance (CBL).

9. The device of claim 8, wherein said circuit means comprise an auxiliary resistance (R3) connected to said power supply line through a second switch controlled by said control signal (BLMEAS_N).

10. The device of claim 8, wherein said circuit means comprise a current generator (IEXT) connected to said power supply voltage line through a pad of the memory device.

11. A non volatile NAND type memory device including a circuit for fixing an evaluation time (Teval) of the programmed or erased state of a cell of an array of rows and columns of cells, individually addressable through word lines and bitlines chargeable at respective read charging voltages, said evaluation time passed from the instant a bitline of a cell is charged at a read charge voltage (V1), a sense circuit assesses the state of the cell in order to produce at output of the memory device a certain read data, the memory device comprising:

at least a dummy bitline;
means for loading said dummy bitline at said read charging voltage (V1);
a constant current generator (Ibias) for discharging said dummy bitline when enabled by a control signal (STARTBLDISCH);
a flag generating circuit (ENDBLDISCH) active when said dummy bitline reaches a pre-established read discrimination voltage level (V2);
a microprocessor receiving said flag (ENDBLDISCH), for generating said control signal (STARTBLDISCH) and fixing the evaluation time (Teval) according to the method of claim 6.

**Patentansprüche**

1. Verfahren zur Festlegung einer Evaluierungszeit (Teval) für einen programmierten oder gelöschten Zustand einer Zelle eines Arrays aus Zeilen und Spalten von Zellen einer nichtflüchtigen NAND-Speichervorrichtung, die einzeln adressierbar sind durch Wortleitungen und Bitleitungen, die aufladbar sind mit bestimmten Lesespannungspegeln, verstrichen die von dem Moment ausgehende Evaluierungszeit, wo eine Bitleitung einer Zelle mit einer Leseladespannung (V1) aufgeladen wird, beurteilt eine Sense-Schaltung den Zustand der Zelle, um an einem Ausgang der Speichervorrichtung bestimmte Lesedaten zu erzeugen, umfassend die Schritte

Festlegen der Evaluierungszeit (Teval) jeder Speichervorrichtung in Abhängigkeit von zumindest der Leseladespannung (V1) der Bitleitung, einer Lesediskriminierspannung (V2) und einem bestimmten Entladestrom durch die Zellen (Icell) einmal für alle während einer Test-on-Wafer-Phase (EWS) der Vorrichtung oder wiederholt während des Betriebs der fertiggestellten Speichervorrichtung; das Verfahren ist **dadurch gekennzeichnet, dass** es die Schritte umfasst:

Messen einer Kapazität einer vorgegebenen Mehrzahl von Bitleitungen des Arrays;
Ermitteln eines Durchschnittswerts der Bitleitungskapazität (CPL) auf Grundlage der gemessenen Kapazität; und
Festlegen der Evaluierungszeit (Teval) der Speichervorrichtung als Funktion des Durchschnittswerts der Bitleitungskapazität (CBL).

2. Verfahren nach Anspruch 1, wobei die Evaluierungszeit (Teval) bei einer Betriebsphase der Speichervorrichtung festgelegt wird, die aus der Anschaltphase und dem Beginn eines Lösch- oder Lesevorgangs ausgewählt wird.

3. Verfahren nach Anspruch 1, beinhaltend die Schritte:

Messen der Gesamtkapazität gerader oder ungerader Bitleitungen des Speicherarrays;
Ermitteln des Durchschnittswerts der Bitleitungskapazität (CBL), indem die gemessene Gesamtkapazität geteilt wird durch die Anzahl entweder gerader oder ungerader, parallel auf die Leseladespannung (V1) geladener Bitleitungen.

4. Verfahren nach Anspruch 3, umfassend die Schritte:

Vorspannen entweder aller geraden oder aller ungeraden Bitleitungen des Speicherarrays durch deren paralleles Anschließen an eine gemeinsame Masseleitung;
paralleles Aufladen der Bitleitungen durch Anschließen der gemeinsamen Leitung an eine Energieversorgungsschiene der Speichervorrichtung mittels eines Hilfswiderstands (R3);
Vergleichen der Spannung auf der gemeinsamen Leitung mit einer Referenzspannung (VREF);
Messen der Aufladezeit (T) der Bitleitungen zum Erreichen einer Spannung auf der gemeinsamen Leitung, die gleich der Referenzspannung (VREF) ist;
Berechnen der Gesamtkapazität der Bitleitungen in Abhängigkeit von der Zeit (T) zum Aufladen des Hilfswiderstands (R3) und der Referenzspannung (VREF).

5. Verfahren nach Anspruch 3, umfassend die Schritte
Vorspannen entweder aller geraden oder aller ungeraden Bitleitungen des Speicherarrays durch deren paralleles Anschließen an eine gemeinsame Masseleitung;
paralleles Aufladen der Bitleitungen durch Anschließen der gemeinsamen Leitung an einen Konstantstromgenerator eines bestimmten Stroms (IEXT);
Vergleichen der Spannung auf der gemeinsamen Leitung mit einer Referenzspannung (VREF);
Messen der Aufladezeit (T) der Bitleitungen zum Erreichen einer Spannung auf der gemeinsamen Leitung, die gleich der Referenzspannung (VREF) ist;
Berechnen der Gesamtkapazität der Bitleitungen in Abhängigkeit von der Zeit (T) zum Aufladen des Hilfswiderstands (R3) und der Referenzspannung (VREF).

6. Verfahren nach Anspruch 2, wobei die Speichervorrichtung zusätzliche Dummy-Bitleitungen-Speicherzellen umfasst, wobei das Verfahren die Schritte des Vorspannens zumindest einer der Dummy-Bitleitungen mit der Leseladespannung (V1) umfasst;
des Entladens der Dummy-Bitleitungen mit dem bestimmten zuvor ermittelten Entladestrom (Icell);
des Festlegens der Evaluierungszeit (Teval) durch Messen der Zeit, die benötigt wird zum Entladen der Dummy-Bitleitung von der Leseladespannung (V1) auf den Lesediskriminierspannungspegel (V2).

7. Verfahren nach Anspruch 1, beinhaltend die Schritte:

Festlegen der Evaluierungszeit (Teval) jeder Speichervorrichtung in Abhängigkeit von zumindest der Leseladespannung (V1) der Bitleitungen, einem Lesediskriminierspannungspegel (V2), einem bestimmten Entladestrom durch die Zelle (Icell) und dem Durchschnittskapazitätswert (CBL) durch das Setzen von Trimmsicherungen der Speichervorrichtung.

**8.** Nichtflüchtige Speichervorrichtung vom NAND-Typ, beinhaltend eine Schaltung zur Festlegung einer Evaluierungszeit (Teval) für einen programmierten oder gelöschten Zustand einer Zelle eines Arrays aus Zeilen und Spalten von Zellen, die einzeln adressierbar sind durch Wortleitungen und Bitleitungen, die aufladbar sind mit jeweiliger Lesespannung, verstrichen die von dem Moment ausgehende Evaluierungszeit, wo eine Bitleitung einer Zelle mit einer Leseladespannung (V1) aufgeladen wird, beurteilt eine Sense-Schaltung den Zustand der Zelle, um am Ausgang der Speichervorrichtung bestimmte Lesedaten zu erzeugen, wobei die Schaltung zur Festlegung der Evaluierungszeit (Teval) umfasst:

einen Spannungsteiler (R1, R2), auf Masse bezogen und angeschlossen an eine Energieversorgungsleitung der Speichervorrichtung durch einen mittels eines Steuersignals (BLMEANS_N) angesteuerten Schalter, zum Erzeugen einer Referenzspannung (VREF);
einen Komparator zum Vergleichen der Spannung auf einer gemeinsamen Leitung der Bitleitungen des Speicherarrays mit der Referenzspannung (VREF), der ein Flag (BLMEASOUT) erzeugt, das aktiv ist, wenn die Referenzspannung (VREF) überschritten wird;

**dadurch gekennzeichnet, dass** die Speichervorrichtung beinhaltet:

Schaltungsmittel zum Aufladen der gemeinsamen Leitung der Bitleitungen, wobei eine Zeit zum Aufladen der gemeinsamen Leitung bestimmt wird auf Grundlage des erzeugten Flags (BLMEASOUT); ein Durchschnittswert der Bitleitungskapazität (CBL) ermittelt wird auf Grundlage der Zeit zum Aufladen der gemeinsamen Leitung; und die Evaluierungszeit (Teval) festgelegt wird als Funktion des Durchschnittswerts der Bitleitungskapazität (CBL).

**9.** Vorrichtung nach Anspruch 8, wobei die Schaltungsmittel einen Hilfswiderstand (RS) umfassen, der an die Energieversorgungsleitung durch einen zweiten Schalter angeschlossen ist, der vom Steuersignal (BLMEAS_N) angesteuert wird.

**10.** Vorrichtung nach Anspruch 8, wobei die Schaltungsmittel einen Stromgenerator (IEXT) umfassen, der an die Energieversorgungsspannungsleitung durch ein Pad der Speichervorrichtung angeschlossen ist.

**11.** Nichtflüchtige Speichervorrichtung vom NAND-Typ, beinhaltend eine Schaltung zur Festlegung einer Evaluierungszeit (Teval) für den programmierten oder gelöschten Zustand einer Zelle eines Arrays aus Zeilen und Spalten von Zellen, die einzeln adressierbar sind durch Wortleitungen und Bitleitungen, die aufladbar sind mit jeweiligen Leseladespannungen, verstrichen die von dem Moment ausgehende Evaluierungszeit, wo eine Bitleitung einer Zelle mit einer Leseladespannung (V1) aufgeladen wird, beurteilt eine Sense-Schaltung den Zustand der Zelle, um am Ausgang der Speichervorrichtung bestimmte Lesedaten zu erzeugen, wobei die Speichervorrichtung umfasst:

zumindest eine Dummy-Bitleitung;
Mittel zum Aufladen der Dummy-Bitleitung mit der Leseladespannung (V1);
einen Konstantstromgenerator (Ibias) zum Entladen der Dummy-Bitleitung, wenn aktiviert durch ein Steuersignal (STARTBLDISCH);
eine Flagerzeugungsschaltung (ENDBLDISCH), die aktiv ist, wenn die Dummy-Bitleitung einen zuvor ermittelten Lesediskriminierspannungspegel (V2) erreicht;
einen das Flag (ENDBLDISCH) empfangenden Mikroprozessor zum Erzeugen des Steuersignals (STARTBLDISCH) und Festlegen der Evaluierungszeit (Teval) in Übereinstimmung mit dem Verfahren nach Anspruch 6.

## Revendications

**1.** Procédé de fixation d'un temps d'évaluation (Teval) de l'état de programmation ou d'effacement d'une cellule d'une matrice de rangées et de colonnes de cellules d'un dispositif de mémoire non volatile du type NAND, adressables individuellement par l'intermédiaire de lignes de mots et de lignes de bits susceptibles d'être chargées à certains niveaux de tension de lecture, ledit temps d'évaluation s'écoulant depuis l'instant où une ligne de bits d'une cellule est chargée à une tension de charge de lecture (V1), un circuit de détection évalue l'état de la cellule afin de produire à une sortie du dispositif de mémoire une certaine donnée de lecture, comprenant les étapes consistant à :

fixer ledit temps d'évaluation (Teval) de chaque dispositif de mémoire en fonction d'au moins ladite tension de charge de lecture (V1) de la ligne de bits, d'une tension de discrimination de lecture (V2) et d'une certaine intensité de décharge traversant les cellules (Icell), une fois pour toutes au cours d'une phase de test pour plaquette de silicium (EWS) du dispositif, ou de manière répétée au cours du fonctionnement du dispositif de mémoire fini ; le procédé est **caractérisé par le fait qu'**il comprend les étapes consistant à :

> mesurer une capacité d'une pluralité prédéfinie de lignes de bits de la matrice ;
> établir une valeur moyenne de la capacité de la ligne de bits (CBL) en se fondant sur la mesure de la capacité ; et
> fixer ledit temps d'évaluation (Teval) du dispositif de mémoire en fonction de ladite valeur moyenne de la capacité de la ligne de bits (CBL).

**2.** Procédé selon la revendication 1, dans lequel ledit temps d'évaluation (Teval) est fixé au moment d'une phase de fonctionnement du dispositif de mémoire choisie parmi la phase de mise sous tension et le moment du commencement d'une opération d'effacement ou de lecture.

**3.** Procédé selon la revendication 1, comprenant les étapes consistant à :

> mesurer la capacité totale des lignes de bits paires ou impaires de la matrice mémoire ;
> établir ladite valeur moyenne de la capacité de la ligne de bits (CBL) en divisant la capacité totale mesurée par le nombre de lignes de bits paires ou de lignes de bits impaires chargées à ladite tension de charge de lecture (V1) en parallèle.

**4.** Procédé selon la revendication 3, comprenant les étapes consistant à :

> polariser soit toutes les lignes de bits paires, soit toutes les lignes de bits impaires de la matrice mémoire en les connectant en parallèle à une ligne de masse commune ;
> charger en parallèle lesdites lignes de bits en connectant ladite ligne commune à un rail d'alimentation électrique du dispositif de mémoire par l'intermédiaire d'une résistance auxiliaire (R3) ;
> comparer la tension régnant sur ladite ligne commune à une tension de référence VREF ; mesurer le temps de charge (T) desdites lignes de bits nécessaire pour atteindre, sur ladite ligne commune, une tension égale à ladite tension de référence (VREF) ;
> calculer la capacité totale desdites lignes de bits en fonction dudit temps de charge (T) de ladite résistance auxiliaire (R3) et de ladite tension de référence (VREF).

**5.** Procédé selon la revendication 3, comprenant les étapes consistant à :

> polariser soit toutes les lignes de bits paires, soit toutes les lignes de bits impaires de la matrice mémoire en les connectant en parallèle à une ligne de masse commune ;
> charger en parallèle lesdites lignes de bits en connectant ladite ligne commune à un générateur de courant constant d'une certaine intensité (IEXT) ;
> comparer la tension régnant sur ladite ligne commune à une tension de référence VREF ; mesurer le temps de charge (T) desdites lignes de bits nécessaire pour atteindre, sur ladite ligne commune, une tension égale à ladite tension de référence (VREF) ;
> calculer la capacité totale desdites lignes de bits en fonction dudit temps de charge (T) de ladite résistance auxiliaire (R3) et de ladite tension de référence (VREF).

**6.** Procédé selon la revendication 2, dans lequel ledit dispositif de mémoire comprend des cellules de mémoire à lignes de bits factices supplémentaires, le procédé comprenant les étapes consistant à :

> polariser au moins une desdites lignes de bits factices à ladite tension de charge de lecture (V1);
> décharger lesdites lignes de bits factices à ladite certaine intensité de décharge préétablie (Icell) ;
> fixer ledit temps d'évaluation (Teval) en mesurant le temps nécessaire pour décharger ladite ligne de bits factice qui passe de ladite tension de charge de lecture (V1) audit niveau de tension de discrimination de lecture (V2).

**7.** Procédé selon la revendication 1, comprenant les étapes consistant à :

> fixer ledit temps d'évaluation (Teval) de chaque dispositif de mémoire en fonction d'au moins ladite tension de charge de lecture (V1) des lignes de bits, d'un niveau de tension de discrimination de lecture (V2), d'une certaine intensité de décharge traversant ladite cellule (Icell) et de ladite valeur moyenne de capacité (CBL) par l'intermédiaire du réglage de fusibles d'appoint du dispositif de mémoire.

8. Dispositif de mémoire non volatile du type NAND comprenant un circuit destiné à fixer un temps d'évaluation (Teval) d'un état de programmation ou d'effacement d'une cellule d'une matrice de rangées et de colonnes de cellules, adressables individuellement par l'intermédiaire de lignes de mots et de lignes de bits susceptibles d'être chargées à une tension de charge de lecture respective, ledit temps d'évaluation s'écoulant depuis l'instant où une ligne de bits d'une cellule est chargée à une tension de charge de lecture (V1), un circuit de détection évalue l'état de la cellule afin de produire à une sortie du dispositif de mémoire une certaine donnée de lecture, ledit circuit destiné à fixer le temps d'évaluation (Teval) comprenant :

un réducteur de tension (R1, R2) se référant à la masse et connecté à une ligne d'alimentation électrique du dispositif de mémoire par l'intermédiaire d'un commutateur commandé par un signal de commande (BLMEANS_N), générant une tension de référence (VREF) ;
un comparateur destiné à comparer la tension régnant sur une ligne commune desdites lignes de bits de la matrice mémoire avec ladite tension de référence (VREF), générant un drapeau (BLMEASOUT) actif lorsque ladite tension de référence (VREF) est dépassée ;

**caractérisé en ce que** le dispositif de mémoire comprend :

un moyen de circuit destiné à charger ladite ligne commune desdites lignes de bits, un temps nécessaire pour charger ladite ligne commune étant déterminé en se fondant sur le drapeau généré (BLMEASOUT) ; une valeur moyenne de la capacité de la ligne de bits (CBL) étant établie en se fondant sur le temps nécessaire pour charger ladite ligne commune ; et le temps d'évaluation (Teval) étant fixé en fonction de ladite valeur moyenne de la capacité de la ligne de bits (CBL).

9. Dispositif selon la revendication 8, dans lequel ledit moyen de circuit comprend une résistance auxiliaire (R3) connectée à ladite ligne d'alimentation électrique par l'intermédiaire d'un second commutateur commandé par ledit signal de commande (BLMEAS_N).

10. Dispositif selon la revendication 8, dans lequel ledit moyen de circuit comprend un générateur de courant (IEXT) connecté à ladite ligne d'alimentation en tension électrique par l'intermédiaire d'une pastille du dispositif de mémoire.

11. Dispositif de mémoire non volatile du type NAND comprenant un circuit destiné à fixer un temps d'évaluation (Teval) de l'état de programmation ou d'effacement d'une cellule d'une matrice de rangées et de colonnes de cellules, adressables individuellement par l'intermédiaire de lignes de mots et de lignes de bits susceptibles d'être chargées à des tensions de charge de lecture respectives, ledit temps d'évaluation s'écoulant depuis l'instant où une ligne de bits d'une cellule est chargée à une tension de charge de lecture (V1), un circuit de détection évalue l'état de la cellule afin de produire à une sortie du dispositif de mémoire une certaine donnée de lecture, le dispositif de mémoire comprenant :

au moins une ligne de bits factice ;
un moyen destiné à charger ladite ligne de bits factice à ladite tension de charge de lecture (V1) ;
un générateur de courant constant (Ibias) destiné à décharger ladite ligne de bits factice lorsque cela lui est indiqué par un signal de commande (STARTBLDISCH) ;
un circuit de génération de drapeau (ENDBLDISCH) actif lorsque ladite ligne de bits factice atteint un niveau préétabli de tension de discrimination de lecture (V2) ;
un microprocesseur recevant ledit drapeau (ENDBLDISCH), destiné à générer ledit signal de commande (STARTBLDISCH) et à fixer le temps d'évaluation (Teval) conformément au procédé selon la revendication 6.

**FIG. 1**

**FIG. 2**

I cell

① Itr ② ③ ④

PV                    Vwl

**FIG. 3**

C[fF]

DRM

+/- 50%

Ccella

\#

**FIG. 4**

**FIG. 5**

**FIG. 6**

**FIG. 7**

**FIG. 8**

C[fF]

WAFER / DIE PARAM

Ccella

+/- 10%

#

**FIG. 9**

PROCESS

EWS

Other PROCESS STEP

LOT PARAMETER MEASURE

BL Capacitance Data

Other PROCESS STEP

Other EWS STEP

Teval Trimming

Other EWS STEP

**FIG. 10**

FIG. 11

$$CBL = Caup + Cadw + 2*Cc + 2*Cfdw + 2*Cfu$$

FIG. 12

FIG. 13

FIG. 14

VIRPWRTOGND @ VDD
VIRPWR @ GND
DISCHx @ VDD
SELBLx @ GND
BLMEAS_N @ VDD

BLMEASOUT

BLMEAS_N

BLMEAS_N

R1

R3

VREF

R2

BLMEAS_N

VIRPWRTOGND

BLMEAS_N @ GND
DISCHE @ HV
DISCHO @ GND
SELBLE @ GND
SELBLO @ VDD

SO @ GND via PB

VIRPWR

BLE<0>  BLO<0>  BLE<1>  BLO<1>  BLE<n>  BLO<n>

SELBLE  DISCHE  DISCHO  SELBLO SELBLE  DISCHE  DISCHO  SELBLO  SELBLE  DISCHE  DISCHO  SELBLO

SO<0>  SO<1>  SO<n>

PB<0>  PB<1>  PB<n>

FIG. 15

EP 1 901 309 B1

EP 1 901 309 B1

BLMEAS_N

BLMEASOUT

VIRPWR(t)

$VREF = VDD*R2/(R2+R1)$

**FIG. 16**

FIG. 17

FIG. 18

EP 1 901 309 B1

FIG. 19

FIG. 20

FIG. 21

FIG. 22

EP 1 901 309 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1610335 A